# EUROPÄISCHE PATENTSCHRIFT

(11) **EP 3 501 875 B1**
(45) Veröffentlichungstag und Bekanntmachung des Hinweises auf die Patenterteilung: **05.01.2022**
(21) Anmeldenummer: 18212015.4
(22) Anmeldetag: 12.12.2018
(51) Int. Cl.: B60L 3/00, H02J 1/02, H02M 1/12, H02M 7/5387, H02M 1/15, H03H 7/42, H02M 1/14, H02J 7/00, H02M 1/44

(54) **TRAKTIONSNETZ IN EINEM ELEKTROFAHRZEUG**
TRACTION NETWORK IN AN ELECTRIC VEHICLE
RÉSEAU DE TRACTION DANS UN VÉHICULE ÉLECTRIQUE

(30) Priorität: 22.12.2017 DE 102017223763
(43) Veröffentlichungstag der Anmeldung: 26.06.2019
(73) Patentinhaber: VOLKSWAGEN AKTIENGESELLSCHAFT, 38440 Wolfsburg (DE); AVL Software And Functions GmbH, 93059 Regensburg (DE)
(72) Erfinder: Waldera, Christian, 38114 Braunschweig (DE); Dr. Obholz, Martin, 38104 Braunschweig (DE); Dr. Arndt, Bastian, 93053 Regensburg (DE); Dr. Olbrich, Peter, 93053 Regensburg (DE)
(74) Vertreter: Zucker, Volker

(56) Entgegenhaltungen:
- EP-A1- 3 255 770
- DE-A1-102009 056 395
- DE-A1-102014 209 143
- US-A- 3 996 537
- US-A1- 2006 158 814

## Beschreibung

Die Erfindung betrifft ein Traktionsnetz in einem Elektrofahrzeug.

Die hohe Spannungslage leistungselektronischer Komponenten in Elektrofahrzeugen bedingt eine erhöhte Störaussendung. Dabei sind insbesondere die Gleichtaktstörimpulse bzw. die Common-Mode-Störungen (CM) auf den Leitungen zwischen Wechselrichter und Hochvolt-Batterie für eine erhöhte Störaussendung verantwortlich. Dies ist vor allem kritisch, da auf der DC-Seite mehr abstrahlfähige Strukturen vorhanden sind.

Mit Hilfe von EMV-Filtern kann diesen Störungen entgegengewirkt werden. Diese bestehen üblicherweise aus kapazitiven Elementen, welche die Störungen nahe der Quelle kurzschließen bzw. induktiven Elementen, welche die Impedanz des Störpfades erhöhen. Um CM-Störungen in Elektrofahrzeugen zu reduzieren, werden primär Y-Kondensatoren zwischen den HV-Leitungen und der Fahrzeugmasse eingesetzt. Da diese Bestandteile der Isolation des HV-Systems sind, sind sie sicherheitskritisch, sodass hier besondere Anforderungen gelten. Gemäß ISO 6469-3 ist die im Kondensator gespeicherte Energie auf einen Wert von 200 mJ zu begrenzen. Bei einem 400-V-Hochvoltsystem entspricht dies einer gesamten Y-Kapazität im Fahrzeug von nur 2,5 µF.

Reichen diese Maßnahmen nicht aus, kann die Störung mit Hilfe von induktiven Elementen in Form von CM-Drosseln entgegengewirkt werden. Diese Maßnahme ist aber sowohl kosten- als auch bauraumintensiv.

In dem Fachartikel "Aktive EMI-Filter zur Reduktion von CM-Störimpulsen auf den HV-Leitungen von Elektrofahrzeugen", präsentiert auf der 7. GMM Fachtagung "EMV im KFZ", 20.09.2017 in Wolfsburg, wird zur Lösung dieses Problems die Verwendung aktiver Filterschaltungen vorgeschlagen.

Dabei wird insbesondere ein aktiver Filter vorgeschlagen, umfassend ein Einkoppelglied aus mindestens zwei Kondensatoren, die in Reihe geschaltet zwischen der positiven Hochvoltleitung und der negativen Hochvoltleitung angeordnet sind, einen Spannungsverstärker, einen Stromverstärker und ein Auskoppelglied. Das Auskoppelglied besteht aus mindestens zwei in Reihe geschalteten Kondensatoren, die zwischen der positiven Hochvoltleitung und der negativen Hochvoltleitung angeordnet sind, wobei der Stromverstärker eine Push-Pull-Stufe aufweist, d.h. zwei komplementäre Transistoren am Ausgang aufweist.

Die EP 3 255 770 A1 offenbart eine Anordnung, umfassend eine Batterie und einen Wechselrichter, die über eine positive Hochvoltleitung und eine negative Hochvoltleitung miteinander verbunden sind, wobei zwischen der positiven Hochvoltleitung und der negativen Hochvoltleitung mindestens ein aktiver Filter zur Reduktion von Gleichtaktstörungspulsen angeordnet ist, wobei zwischen der Batterie und dem aktiven Filter mindestens ein passiver Gleichtaktfilter angeordnet ist.

Aus der DE 10 2014 209 143 A1 ist ein potentialfreies Gleichspannungsnetz, insbesondere ein Traktionsnetz eines Elektro- oder Hybridfahrzeugs, bekannt, umfassend eine Gleichspannungsquelle, einen Wechselrichter sowie mindestens einen an den Wechselrichter angeschlossenen elektrischen Verbraucher, wobei zwischen dem elektrischen Verbraucher und Masse sich mindestens eine parasitäre Kapazität ausbildet, wobei zwischen der Gleichspannungsquelle und dem Wechselrichter eine Gleichtaktinduktivität angeordnet ist.

Aus der DE 10 2009 056 395 A1 ist ein Verfahren zur Funktionsprüfung von elektrischen Filtern bekannt, wobei im Bereich eines Eingangs des Filters ein Signal eingeleitet sowie im Bereich des Ausgangs des Filters ein Resultatsignal erfasst wird. Eine Auswertungseinheit vergleicht das Resultatsignal mit einem Erwartungssignal, wobei bei einer Mindestabweichung eine Fehlfunktion des Filters detektiert wird.

Aus der US 2006/0158814 A1 und der US 3,996,857 A sind weitere passive Gleichtaktfilter bekannt.

Der Erfindung liegt das technische Problem zugrunde, ein Traktionsnetz für ein Elektrofahrzeug zu schaffen, bei dem die Gleichtaktstörimpulse verbessert unterdrückt werden.

Die Lösung des technischen Problems ergibt sich durch ein Traktionsnetz mit den Merkmalen des Anspruchs 1. Weitere vorteilhafte Ausgestaltungen der Erfindung ergeben sich aus den Unteransprüchen.

Hierzu umfasst das Traktionsnetz in einem Elektrofahrzeug eine Traktionsbatterie und einen Wechselrichter, die über eine positive Hochvoltleitung und eine negative Hochvoltleitung miteinander verbunden sind, wobei zwischen der positiven Hochvoltleitung und der negativen Hochvoltleitung mindestens ein aktiver Filter zur Reduktion von Gleichtaktstörimpulsen angeordnet ist, wobei zwischen der Traktionsbatterie und dem aktiven Filter mindestens ein passiver Gleichtaktfilter angeordnet ist. Hierdurch wird erreicht, dass die Anforderungen an die Spannungsfestigkeit des aktiven Filters herabgesetzt werden, wobei der passive Filter selbst einfach aufgebaut sein kann, da dieser nur die Störimpulse im hohen Frequenzbereich von beispielsweise 2 MHz bis 108 MHz unterdrücken soll, wohingegen im Frequenzbereich von 100 kHz bis 2 MHz die Unterdrückung primär durch den aktiven Filter erfolgt. Bei den hohen Frequenzen von 2 MHz und größer sind die benötigten Induktivitäten und/oder Kapazitäten gering, sodass sowohl Kosten und Bauraum des passiven Filters gering sind im Vergleich zu einer vollständigen Kompensation mittels eines passiven Filters über den ganzen Frequenzbereich.

Dabei ist der passive Gleichtaktfilter mehrteilig ausgebildet und weist induktive und kapazitive Elemente auf, wobei zwischen zwei induktiven Elementen jeweils ein Y-Kondensator zwischen der positiven und der negativen Hochvoltleitung und Masse angeordnet ist. Die so entstehende T-Struktur hat sich als besonders geeignet erwiesen. Die induktiven Elemente sind dabei als Ferritringe ausgebildet. Dabei ist vorgesehen, dass die Hochvoltleitungen durch die Ferritringe nur durchgeführt sind, also nicht um diese gewickelt sind, was die Herstellung extrem vereinfacht.

In einer Ausführungsform weist der aktive Filter eine Eingangsstufe, einen Vorverstärker und einen Endverstärker auf.

In einer weiteren Ausführungsform weist der aktive Filter einen aktiven HF-Filter und einen aktiven LF-Filter auf. Dies ermöglicht auch hinsichtlich der Wahl der Bauelemente eine optimierte Anpassung an die jeweiligen Frequenzbereiche. Allerdings benötigt dies relativ viele Bauelemente.

Alternativ kann daher der aktive Filter auch als kombinierter HF/LF-Filter ausgebildet sein.

In einer weiteren Ausführungsform ist zwischen dem aktiven Filter und dem Wechselrichter ein weiterer passiver Filter angeordnet, der vorzugsweise als Ferritring ausgebildet ist. Dies hat den Vorteil, dass die Unterdrückung der Störimpulse direkt am Entstehungsort erfolgt. Dabei kann auch hier vorgesehen sein, dass die Hochvoltleitungen nur durch den Ferritring durchgeführt sind.

Die Erfindung wird nachfolgend anhand eines bevorzugten Ausführungsbeispiels näher erläutert. Die Figuren zeigen:
- Fig. 1: ein schematisches Blockschaltbild eines Traktionsnetzes in einer ersten Ausführungsform,
- Fig. 2: eine Schaltung eines ersten passiven Gleichtaktfilters,
- Fig. 3: ein schematisches Blockschaltbild eines aktiven Filters,
- Fig. 4: eine Schaltung eines HF-Vorverstärkers,
- Fig. 5: eine Schaltung einer HF-Endstufe,
- Fig. 6: eine Schaltung eines LF-Vorverstärkers,
- Fig. 7: eine Schaltung einer LF-Endstufe,
- Fig. 8: ein schematisches Blockschaltbild eines Traktionsnetzes in einer zweiten Ausführungsform,
- Fig. 9: eine Schaltung einer Eingangsstufe
- Fig. 10: eine Schaltung eines Vorverstärkers und
- Fig. 11: eine Schaltung einer Endstufe.

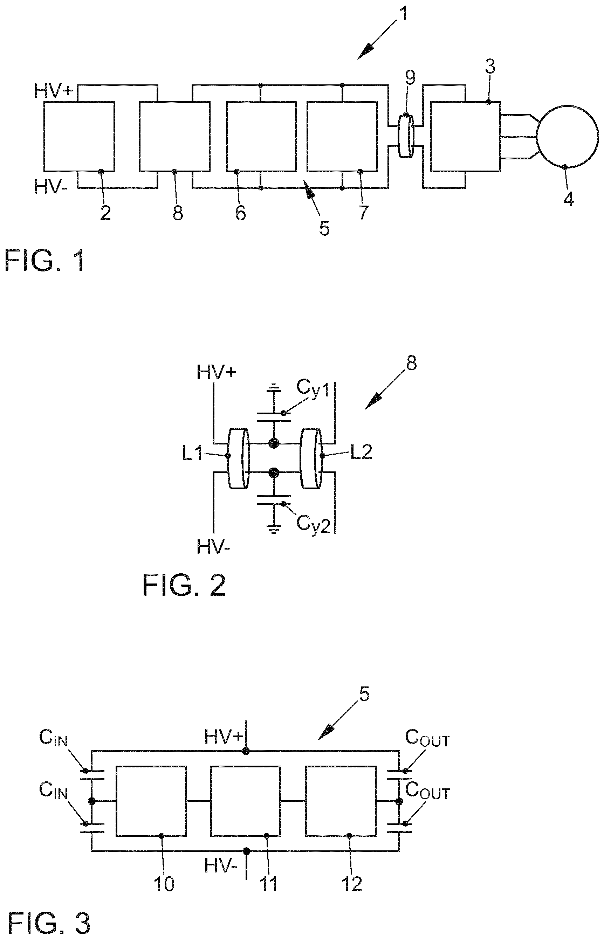

In der Fig. 1 ist ein Traktionsnetz 1 in einer ersten Ausführungsform dargestellt. Das Traktionsnetz 1 umfasst eine Traktionsbatterie 2 und einen Wechselrichter 3, an den ein Elektromotor 4 angeschlossen ist. Die Traktionsbatterie 2 und der Wechselrichter 3 sind über eine positive Hochvoltleitung HV+ und eine negative Hochvoltleitung HV- miteinander verbunden. Weiter weist das Traktionsnetz 1 einen aktiven Filter 5 auf, der aus einem aktiven HF-Filter 6 und einen aktiven LF-Filter 7 besteht. Zwischen dem aktiven Filter 5 und der Traktionsbatterie 2 ist ein erster passiver Gleichtaktfilter 8 angeordnet. Ein weiterer passiver Gleichtaktfilter 9 ist zwischen dem aktiven Filter 5 und dem Wechselrichter 3 angeordnet.

Eine bevorzugte Ausführungsform des passiven Gleichtaktfilters 8 ist in Fig. 2 dargestellt. Der passive Gleichtaktfilter 8 weist ein erstes induktives Element L1 und ein zweites induktives Element L2 auf, die beide als Ferritringe ausgebildet sind. Zwischen den beiden induktiven Elementen L1, L2 ist jeweils ein Kondensator C_{Y1}, C_{Y2} angeordnet, der zwischen der positiven Hochvoltleitung HV+ bzw. der negativen Hochvoltleitung HV- und Masse angeordnet ist, sodass eine T-Struktur entsteht.

In der Fig. 3 ist der grundsätzliche Aufbau eines aktiven Filters 5 dargestellt. Der aktive Filter 5 weist eine Eingangsstufe 10, einen Vorverstärker 11 sowie einen Endverstärker 12 bzw. Endstufe auf, wobei die Signale durch Eingangskondensatoren C_{IN} eingekoppelt und durch Ausgangskondensatoren C_{OUT} ausgekoppelt wurden. Die Eingangs- und Ausgangskondensatoren C_{IN}, C_{OUT} können dabei durch mehrere parallel geschaltete Kondensatoren gebildet werden.

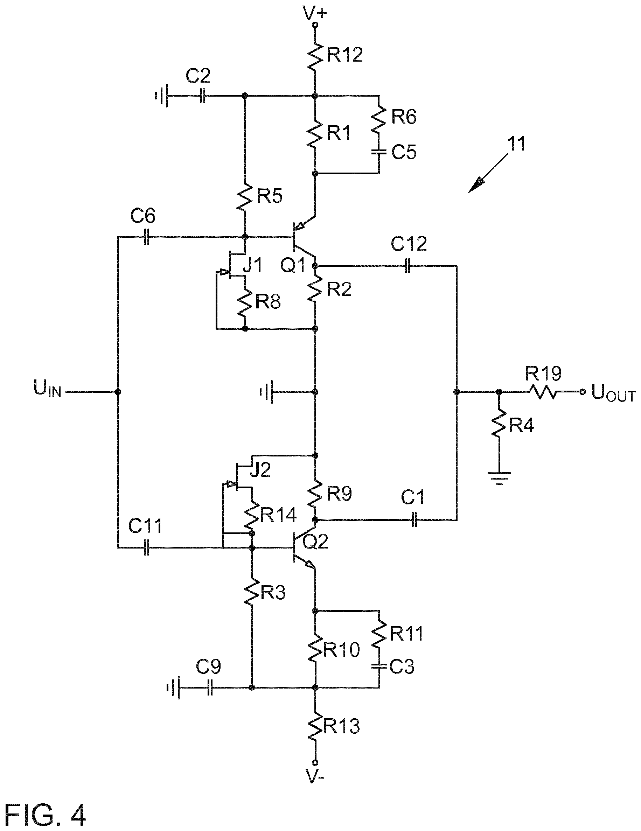

In der Fig. 4 ist eine mögliche Ausführungsform eines HF-Verstärkers 11 dargestellt. Das Eingangssignal Uᵢₙ wid durch die beiden Kondensatoren C6, C11 eingekoppelt und durch eine Push-Pull-Stufe aus den beiden komplementären Transistoren Q1, Q2 verstärkt und invertiert. Über die Auskoppelkondensatoren C12, C1 wird dann das Ausgangssignal Uₒᵤₜ für den Endverstärker 12 zur Verfügung gestellt. Die beiden Junction-FET J1, J2 bilden zusammen mit den Widerständen R5, R8 bzw. R3, R14 jeweils eine Stromquelle, um temperaturstabilisiert die Arbeitspunkte der Push-Pull-Stufe einzustellen. Über den Widerstand R4 wird ein Floaten des Potentials verhindert. Über die Kondensatoren C2, C9 wird die Versorgungsspannung V+, V-entkoppelt. Gleichzeitig bilden die beiden Kondensatoren C2, C9 eine schnelle Energiequelle für Umladevorgänge in den Transistoren Q1, Q2 der Push-Pull-Stufe.

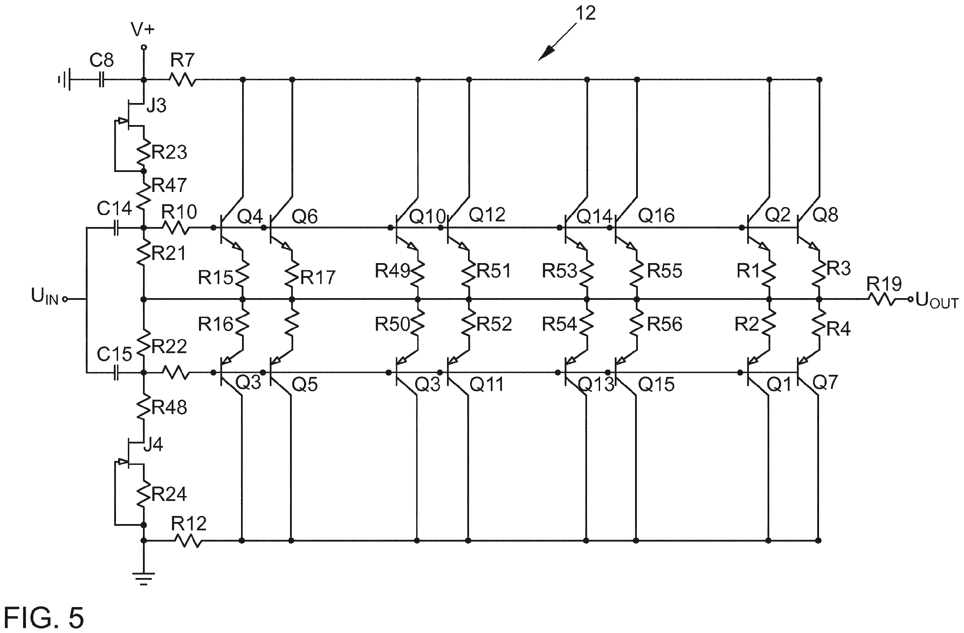

In der Fig. 5 ist ein HF-Endverstärker 12 dargestellt. Dabei wird die Ausgangsspannung Uₒᵤₜ des Vorverstärkers 11 als Eingangsspannung Uᵢₙ kapazitiv über die Kondensatoren C14, C15 eingekoppelt und über acht Push-Pull-Stufen verstärkt. Die Emitter-Widerstände der Transistoren der Push-Pull-Stufen (auch jeweils mit Rₒᵤₜ gekennzeichnet) dienen zur Stabilisierung, um die Schwingungsneigung zu reduzieren. Die beiden Junction-FETs J3, J4 arbeiten wieder als Stromquelle, um die Arbeitspunkte der Push-Pull-Transistoren temperaturstabilisiert einzustellen.

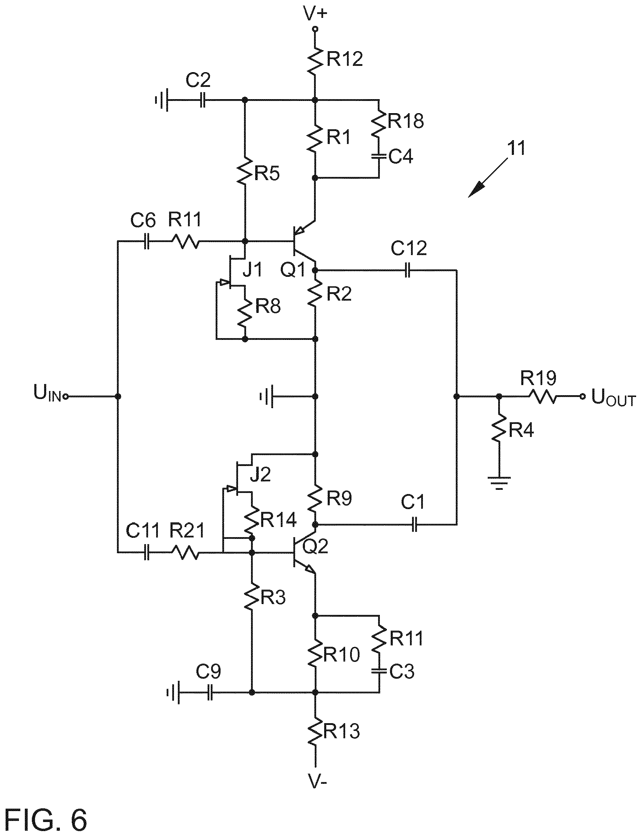

In der Fig. 6 ist eine Schaltungsanordnung für einen LF-Vorverstärker 11 dargestellt, der ähnlich dem HF-Verstärker 11 gemäß Fig. 4 aufgebaut ist, sodass auf die dortige Beschreibung verwiesen werden kann.

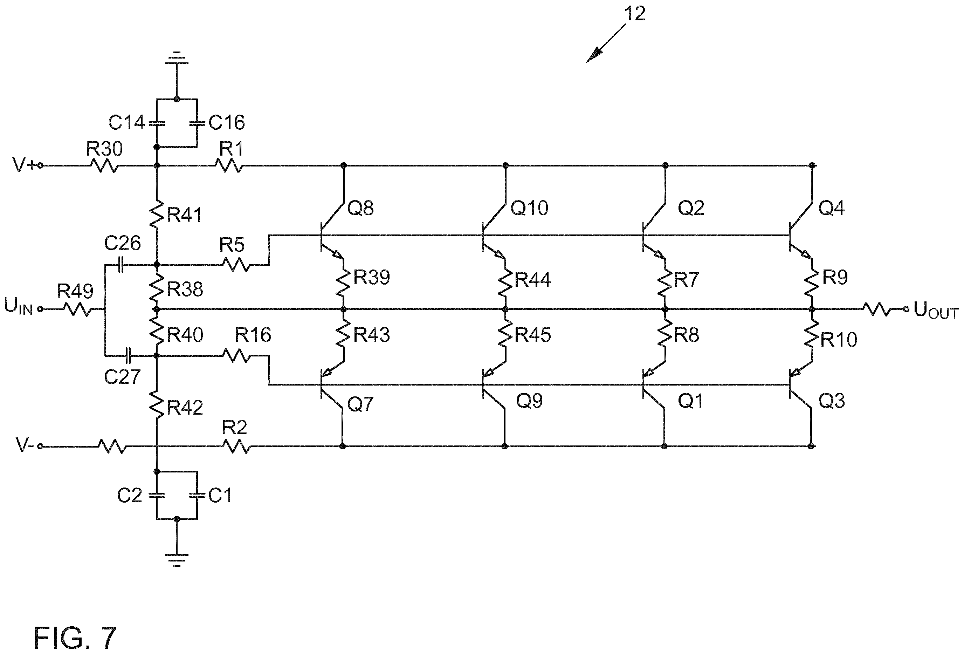

In der Fig. 7 ist eine LF-Endstufe 12 dargestellt, die weitgehend der Schaltung gemäß Fig. 5 entspricht. Wesentlicher Unterschied ist, dass zur Entkopplung der Versorgungsspannung V+, V- nicht jeweils ein Kondensator verwendet wird, sondern ein Kondensatorpaar C14, C16 bzw. C1, C2, wobei die Kondensatoren C14, C16 bzw. C1, C2 eines Kondensatorpaares parallel geschaltet sind. Dabei ist jeweils ein Kondensator eines Kondensatorpaares ein Vielfaches kleiner als der andere Kondensator. Der Faktor liegt beispielsweise zwischen 20 - 30. Insbesondere bei höheren Frequenzen ist der kleine Kondensator aufgrund geringer parasitärer Induktivitäten schneller. Die Größe ist dabei hinsichtlich der Kapazität weniger kritisch, da die Störleistungen im höheren Frequenzbereich kleiner sind.

Der Vorteil eines aktiven HF-Filters 6 und eines aktiven LF-Filters 7 ist, dass die Bauteile an ihre jeweiligen Frequenzbereiche z.B. 0,5 MHz bis 5 MHz für HF und 0,1 MHz bis 0,5 MHz für LF optimal angepasst werden können. Nachteilig ist der erhöhte Bauteileaufwand.

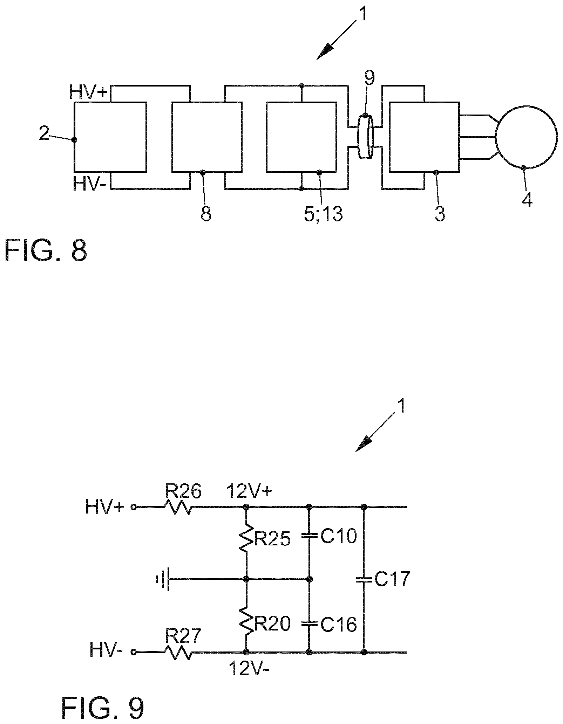

In der Fig. 8 ist ein Blockschaltbild eines alternativen Traktionsnetzes 1 mit einem kombinierten HF/LF-Filter 13 dargestellt.

In der Fig. 9 ist eine Eingangsstufe 10 dargestellt, mittels derer die Spannung heruntertransformiert wird.

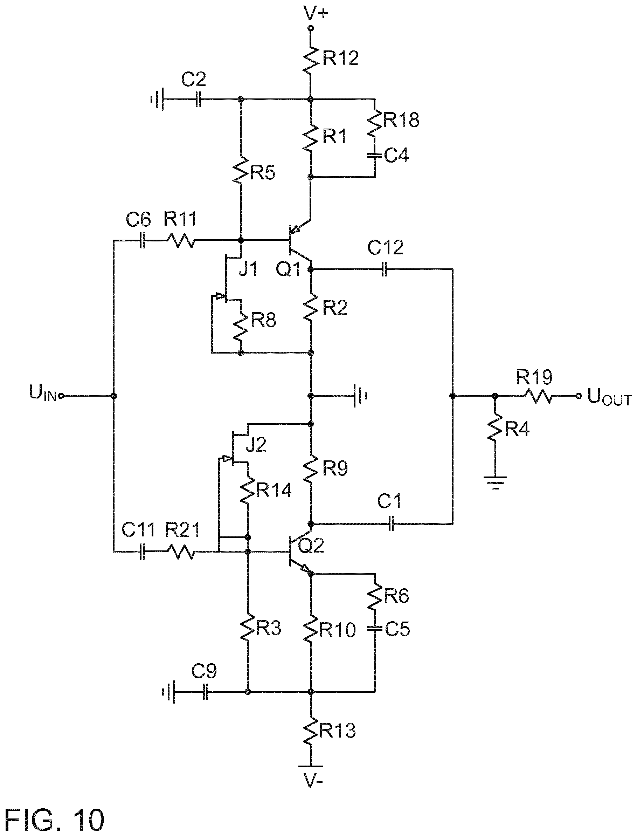

In der Fig. 10 ist ein HF-Vorverstärker 11 des HF/LF-Filters 13 dargestellt, wobei hinsichtlich der Schaltung auf Fig. 4 verwiesen werden kann.

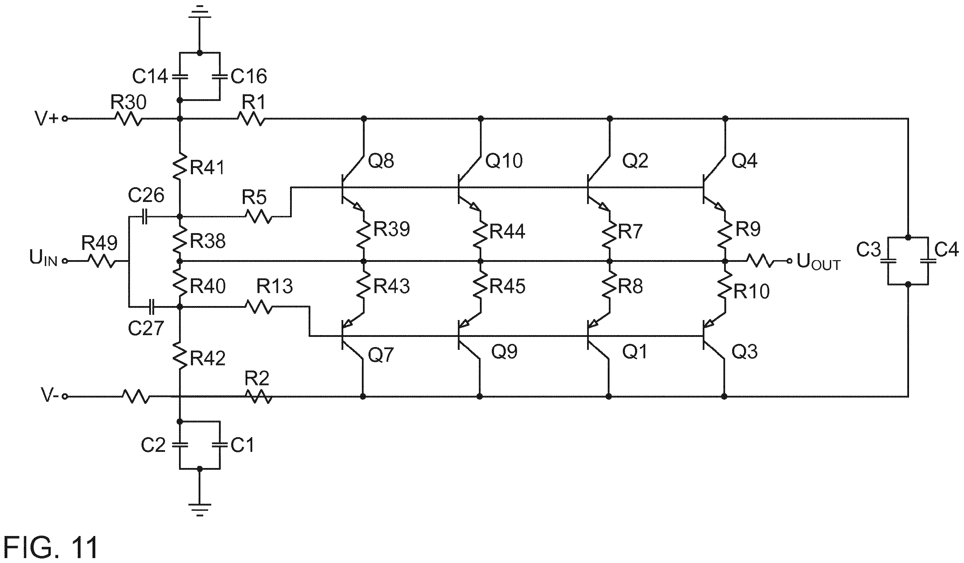

Schließlich ist in der Fig. 11 der LF-Endverstärker 12 dargestellt, wobei auf die Ausführungen zu Fig. 7 Bezug genommen wird. Zusätzlich ist ein weiteres Kondensatorpaar C3, C4 vorgesehen, die parallel geschaltet sind und zwischen den Kollektoren der Push-Pull-Stufen eingeordnet sind. Auch hier weist der eine Kondensator eine vielfach höhere Kapazität auf als der andere Kondensator, sodass der kleinere Kondensator für schnelle Umladevorgänge im HF-Bereich zur Verfügung steht.

Der Vorteil eines aktiven kombinierten HF-LF-Filters 13 ist der geringe Bauraum, die Reduzierung der Bauteile sowie der schnelle HF-Vorverstärker. Da in der Eingangsstufe nur die Versorgungsspannung gefiltert wird, kommt es nur zu einem geringen zeitlichen Versatz zwischen Stör- und Kompensationssignal. Die etwas schlechtere Filterwirkung im HF-Bereich kann durch entsprechende Dimensionierung der passiven Gleichtaktfilter 8, 9 kompensiert werden.

## Patentansprüche

1. Traktionsnetz (1) für ein Elektrofahrzeug, umfassend eine Traktionsbatterie (2) und
einen Wechselrichter (3), die über eine positive Hochvoltleitung (HV+) und eine negative Hochvoltleitung (HV-) miteinander verbunden sind, wobei zwischen der positiven Hochvoltleitung (HV+) und der negativen Hochvoltleitung (HV-) mindestens ein aktiver Filter (5) zur Reduktion von Gleichtaktstörimpulsen angeordnet ist, wobei zwischen der Traktionsbatterie (2) und dem aktiven Filter (5) mindestens ein passiver Gleichtaktfilter (8) angeordnet ist, wobei
der passive Gleichtaktfilter (8) mehrteilig ausgebildet ist und induktive und kapazitive Elemente aufweist, wobei zwischen zwei als Ferritringe ausgebildeten induktiven Elementen (L1, L2) jeweils ein Kondensator (C_{Y1}, C_{Y2}) zwischen der positiven Hochvoltleitung (HV+) und der negativen Hochvoltleitung (HV-) und Masse angeordnet ist, wobei die Hochvoltleitungen (HV+, HV-) gemeinsam durch die Ferritringe nur durchgeführt sind.

2. Traktionsnetz nach Anspruch 1, **dadurch gekennzeichnet, dass** der aktive Filter (5) eine Eingangsstufe (10), einen Vorverstärker (11) und einen Endverstärker (12) aufweist.

3. Traktionsnetz nach einem der vorangegangenen Ansprüche, **dadurch gekennzeichnet, dass** der aktive Filter (5) einen aktiven HF-Filter (6) und einen aktiven LF-Filter (7) aufweist.

4. Traktionsnetz nach einem der Ansprüche 1 oder 2, **dadurch gekennzeichnet, dass** der aktive Filter (5) als kombinierter HF/LF-Filter (13) ausgebildet ist.

5. Traktionsnetz nach einem der vorangegangenen Ansprüche, **dadurch gekennzeichnet, dass** zwischen dem aktiven Filter (5) und dem Wechselrichter (3) ein weiterer passiver Filter (9) angeordnet ist.

6. Traktionsnetz nach Anspruch 5, **dadurch gekennzeichnet, dass** der weitere passive Filter (9) als Ferritring ausgebildet ist.

7. Traktionsnetz nach Anspruch 6, **dadurch gekennzeichnet, dass** die Hochvoltleitungen (HV+, HV-) durch den Ferritring nur durchgeführt sind.

## Claims

1. Traction network (1) for an electric vehicle, comprising a traction battery (2) and an inverter (3), which are connected to one another via a positive high-voltage line (HV+) and a negative high-voltage line (HV- ), wherein at least one active filter (5) for reducing common-mode interference pulses is arranged between the positive high-voltage line (HV+) and the negative high-voltage line (HV-), wherein at least one passive common-mode filter (8) is arranged between the traction battery (2) and the active filter (5), wherein
the passive common-mode filter (8) is formed in multiple parts and has inductive and capacitive elements, wherein between two inductive elements (L1, L2) formed as ferrite rings a respective capacitor (C_{Y1}, C_{Y2}) is arranged between the positive high-voltage line (HV+) and the negative high-voltage line (HV-) and earth, wherein the high-voltage lines (HV+, HV-) are only guided through the ferrite rings together.

2. Traction network according to Claim 1, **characterized in that** the active filter (5) has an input stage (10), a preamplifier (11) and an output amplifier (12).

3. Traction network according to one of the preceding claims, **characterized in that** the active filter (5) has an active HF filter (6) and an active LF filter (7).

4. Traction network according to one of Claims 1 or 2, **characterized in that** the active filter (5) is formed as a combined HF/LF filter (13).

5. Traction network according to one of the preceding claims, **characterized in that** a further passive filter (9) is arranged between the active filter (5) and the inverter (3).

6. Traction network according to Claim 5, **characterized in that** the further passive filter (9) is formed as a ferrite ring.

7. Traction network according to Claim 6, **characterized in that** the high-voltage lines (HV+, HV-) are only guided through the ferrite ring.

## Revendications

1. Réseau de traction (1) pour un véhicule électrique, comprenant une batterie de traction (2) et un onduleur (3) qui sont reliés l'un à l'autre par une ligne haute tension positive (HV+) et une ligne haute tension négative (HV-), au moins un filtre actif (5) destiné à réduire des impulsions parasites en mode commun étant disposé entre la ligne haute tension positive (HV+) et la ligne haute tension négative (HV-), au moins un filtre de mode commun passif (8) étant disposé entre la batterie de traction (2) et le filtre actif (5), le filtre de mode commun passif (8) étant réalisé en plusieurs parties et présentant des éléments inductifs et capacitifs, dans lequel, entre deux éléments inductifs (L1, L2) réalisés sous la forme de deux anneaux en ferrite, respectivement un condensateur (C_{Y1}, C_{Y2}) est disposé entre la ligne haute tension positive (HV+) et la ligne haute tension négative (HV-) et la masse, les lignes haute tension (HV+, HV-) ne faisant que traverser les anneaux en ferrite.

2. Réseau de traction selon la revendication 1, **caractérisé en ce que** le filtre actif (5) présente un étage d'entrée (10), un préamplificateur (11) et un amplificateur de puissance (12).

3. Réseau de traction selon l'une quelconque des revendications précédentes, **caractérisé en ce que** le filtre actif (5) présente un filtre HF actif (6) et un filtre LF actif (7).

4. Réseau de traction selon l'une quelconque des revendications 1 ou 2, **caractérisé en ce que** le filtre actif (5) est réalisé sous la forme d'un filtre HF/LF combiné (13).

5. Réseau de traction selon l'une quelconque des revendications précédentes, **caractérisé en ce qu'**un autre filtre passif (9) est disposé entre le filtre actif (5) et l'onduleur (3).

6. Réseau de traction selon la revendication 5, **caractérisé en ce que** l'autre filtre passif (9) est réalisé sous la forme d'un anneau en ferrite.

7. Réseau de traction selon la revendication 6, **caractérisé en ce que** les lignes haute tension (HV+, HV-) ne font que traverser l'anneau en ferrite.
